# EUROPEAN PATENT APPLICATION

(11) **EP 2 728 403 A1**
(43) Date of publication of application: **07.05.2014**
(21) Application number: 13190292.6
(22) Date of filing: 25.10.2013
(51) Int. Cl.: G02F 1/1343, G02F 1/1362

(54) **Array substrate and display device**

(30) Priority: 02.11.2012 CN 201210434607
(71) Applicant: Boe Technology Group Co. Ltd., Beijing 100015 (CN)
(72) Inventor: Um, Yoon Sun, 100176 Beijing (CN); Choi, Hyun Sic, 100176 Beijing (CN); Xu, Zhiqiang, 100176 Beijing (CN); Li, Hui, 100176 Beijing (CN)
(74) Representative: Brötz, Helmut

(57) **Abstract**

Embodiments of the present application provide an array substrate comprising: a base substrate, and a plurality of gate lines (102), a plurality of data lines (303) and a plurality of pixel units defined by the gate lines and the data lines, which are formed on the base substrate, the pixel units comprising thin film transistors, pixel electrodes (701) and common electrodes (501), projections of the data lines (303) and the common electrodes (501) on the base substrate not coinciding with each other. The embodiments of the present application also provide a display device comprising the above array substrate.

## Description

### TECHNICAL FIELD

Embodiments of the present invention relate to an array substrate and a display device.

### BACKGROUND

ADvanced Super Dimension Switch (hereinafter referred to as ADS for short) is a core technology of an in-plane electric field wide-viewing-angle which forms a multi-dimensional electric field through electric fields generated between edges of slit electrodes in the same plane and an electric field generated between a slit electrode layer and a plate electrode layer so that all the oriented liquid crystal molecules between the slit electrodes and over the electrodes in a liquid crystal cell can be rotated. And thus working efficiency of the liquid crystal is increased and transmittance is enhanced. ADS can improve the image quality of a thin film transistor-liquid crystal display (TFT-LCD) product and have advantages of high resolution, high transmittance, low power consumption, wide viewing angle, high aperture opening ratio, low chromatic aberration, no push mura and the like.

ADS panels are currently widely used, improvements thereof include a high aperture opening ratio ADS (also known as H-ADS). Common ADS display panels with a small size and a high aperture opening ratio acquire a high aperture opening ratio by shielding data lines, and the conventional way of shielding is to shield the data lines by common electrodes, i.e. disposing common electrodes over the data lines as well. However, coupling capacitance is generated between the data lines and the common electrodes. And for a display panel, the number of data lines disposed thereon is large and voltages applied to the data lines are varied. Therefore, load of the data IC will be increased hence the increase of the power consumption of the panel.

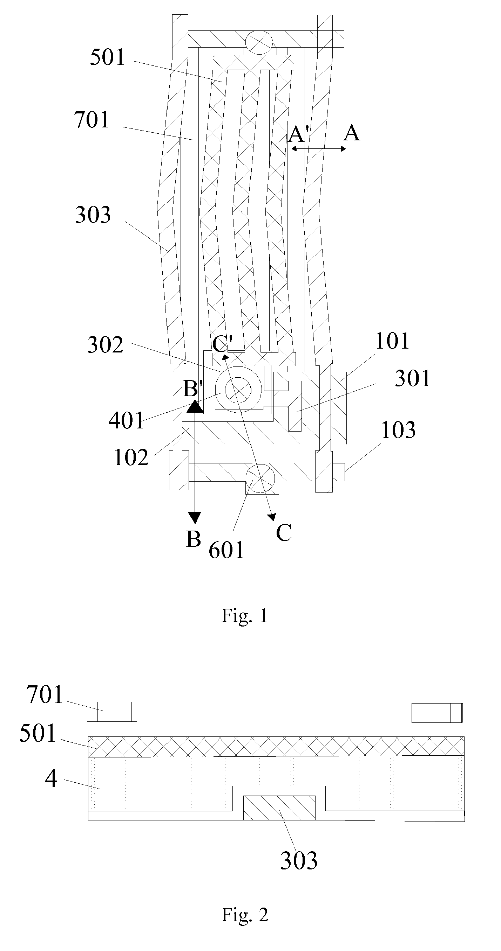

To solve the above problem, there is an ADS display panel using a layer of resin layer in the conventional arts. As shown in Figs. 1 to 4, on the array substrate of the display panel, a gate metal layer (including gates 101, gate lines 102 and common electrode lines 103), a gate insulating layer 2, a source and drain metal layer (including source electrodes 301, drain electrodes 302 and data lines 303), a resin layer 4, a common electrode layer (including common electrodes 501), a passivation layer 6 and a pixel electrode layer (including a plurality of pixel electrodes 701 in a form of striped-shape) are sequentially formed. The pixel electrodes 701 are electrically connected to the drain electrodes 301 through via holes 601 in the passivation layer 6 and via holes 401 in the resin layer 4, and the common electrodes 501 are electrically connected to the common electrode lines 103 through via holes 601 in the passivation layer 6. After the gate metal layer and the source drain metal layer are formed, a layer of the resin layer 4 is coated on the display panel through a coating process, and then structures like the common electrodes 501 and the pixel electrodes 701 are formed over the resin layer 4, wherein the common electrodes 501 is not only formed over the display region but also over data lines 303. The disposition of the resin layer 4 reduces the coupling between the data lines 303 and the common electrodes 501, reducing power consumption of the panel so that the undesirable caused by the coupling capacitance is improved.

However, since the resin layer 4 is added, it needs forming via holes in the resin layer to realize the electrical connection between the pixel electrodes 701 and the drain electrodes 302. Due to the resin layer, a distance between the pixel electrodes 701 and the drain electrodes 302 is increased and thus the upper opening of the via hole in the resin layer is made larger than that of the conventional passivation layer. And as the drain electrodes 302 have a certain width, width of a black array of a color film corresponding to the drain electrodes 302 will be made greater to prevent light leakage. With the size of the panel increased and the resolution improved, the area of the pixels is made increasingly smaller, which renders a larger loss in aperture opening ratio, affecting the resolution of the panel.

### SUMMARY

The embodiment of the present invention provides an array substrate and a display device which avoid the undesirable caused by the coupling between data lines and common electrodes and high power consumption while ensuring a high aperture opening ratio and a high resolution.

According to one aspect of the disclosure, an array substrate comprising: a base substrate a plurality of gate lines, a plurality of data lines and a plurality of pixel units defined by the gate lines and the data lines, the pixel units including thin film transistors, pixel electrodes and common electrodes wherein the projections of the data lines and the common electrodes on the base substrate do not coincide.

In an embodiment of the present invention, the common electrodes are disposed over the gate lines.

In an embodiment of the present invention, the pixel electrodes are slit pixel electrodes, the common electrodes are plate electrodes, and each of the slit pixel electrodes is disposed parallel with the gate lines.

In an embodiment of the present invention, the common electrodes are slit common electrodes, the pixel electrodes are plate electrodes, and each of the slit common electrodes is disposed parallel with the gate lines.

In an embodiment of the present invention, one of the slit common electrodes is disposed over the gate lines, and the projection of the slit common electrode on the array substrate covers the projection of the gate lines on the base substrate.

In an embodiment of the present invention, an insulating layer is further disposed between the pixel electrodes and the common electrodes.

In an embodiment of the present invention, the pixel electrodes and the common electrodes are both slit electrodes and alternatively disposed in the same layer.

In an embodiment of the present invention, an insulating layer is disposed between the gate lines and the common electrodes.

In an embodiment of the present invention, an insulating layer is disposed between the pixel electrodes and the data lines.

In an embodiment of the present invention, the pixel electrodes and the data lines are in the same layer.

According to another aspect of the present disclosure, a display device is provided, including the array substrate of any one of the above.

In the array substrate and the display device provided by the embodiments of the present invention, the data lines and the common electrodes do not overlap with each other, that is, the projections of the data lines and the common electrodes on the base substrate do not coincide, so that the coupling capacitance C_{dc} between the data lines and the common electrodes is minimized. Accordingly, the load of the data lines is lowered and the power consumption of the panel drops so that degradation related to display quality caused by the coupling between the data lines and the common electrodes is avoided. In addition, the structure of the array substrate is simple, and easy to manufacture, and aperture opening ratio under the same condition is higher and more suitable to larger panels compared to the structure in the conventional art in which a resin layer is interposed.

### BRIEF DESCRIPTION OF THE DRAWINGS

In order to clearly illustrate the technical solution of the embodiments of the invention, the drawings of the embodiments will be briefly described in the following; it is obvious that the described drawings are only related to some embodiments of the invention and thus are not limitative of the invention.

Fig. 1 is a structural diagram of a structure of the conventional array substrate in which a resin layer is interposed;

Fig. 2 is a cross sectional view of the array substrate taken along A-A' line in Fig. 1;

Fig. 3 is a cross sectional view of the array substrate taken along B-B' line in Fig. 1;

Fig. 4 is a cross sectional view of the array substrate taken along C-C' line in Fig. 1;

Fig. 5 is a structural diagram of an array substrate according one embodiment of the present invention;

Fig. 6 is a cross sectional view of the array substrate taken along A₁-A₁' line in Fig. 5; and

Fig. 7 is a cross sectional view of the array substrate taken along B₁-B₁' line in Fig. 5.

### DETAILED DESCRIPTION

In order to make objects, technical details and advantages of the embodiments of the invention apparent, the technical solutions of the embodiment will be described in a clearly and fully understandable way in connection with the drawings related to the embodiments of the invention. It is obvious that the described embodiments are just a part but not all of the embodiments of the invention. Based on the described embodiments herein, those skilled in the art can obtain other embodiment(s), without any inventive work, which should be within the scope of the invention.

Referring to the figures, the array substrate and the display device proposed by the embodiments of the present invention will be explained in details as follows.

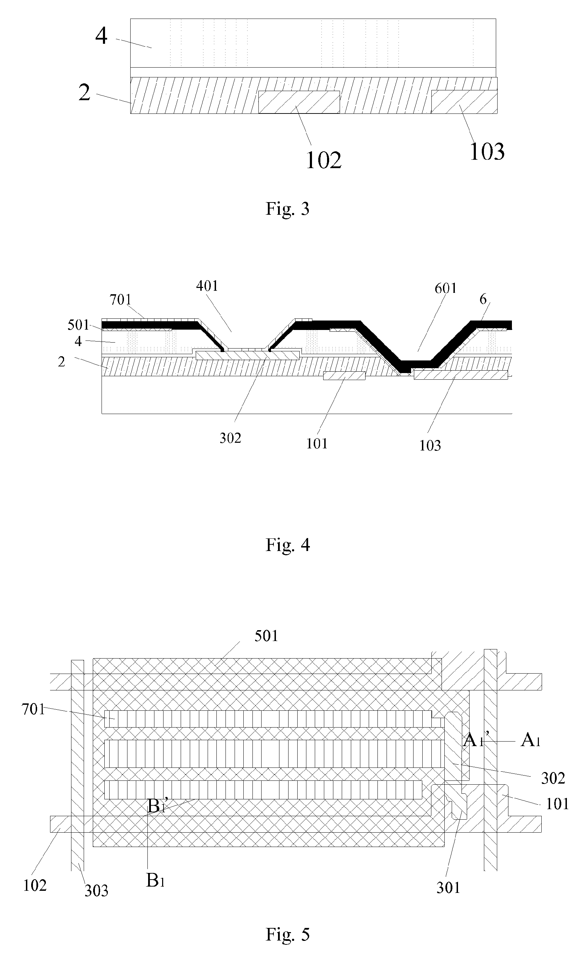

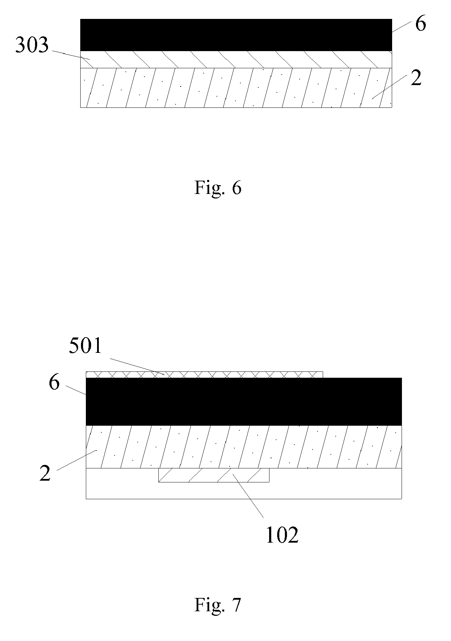

As illustrated in Figs. 5 to 7, an array substrate according to one embodiment of the present invention includes a base substrate, a plurality of gate lines 102, a plurality of data lines 303 and a plurality of pixel units defined by the gate lines 102 and the data lines 303, which are formed on the base substrate, and the pixel units includes a thin film transistor, pixel electrodes 701 and common electrodes 501. The array substrate also includes common electrode lines (not illustrated) connected to the common electrodes. The gate 101 and the gate lines 102 of the thin film transistors are formed in the same layer, a source 301 is connected to the data lines 303, a drain 302 is connected to the pixel electrodes 701 through via holes (not illustrated). The data lines 303 are overlapping with the common electrodes, that is, the projection of the data lines 303 on the base substrate do not coincide with the projection of the common electrode 501 on the base substrate. This can ensure that there is no common electrode over the data lines on the array substrate so that coupling capacitance C_{dc} between the common electrodes and the data lines is minimized. Furthermore, the common electrodes 501 are disposed over the gate lines 102 without the data lines 303 overlapping with the common electrodes 501. Furthermore, an insulating layer is disposed between the gate lines 102 and the common electrodes 501 in order to ensure no electrical connection therebetween. As illustrated in Fig. 7, the common electrodes 501 cover the gate lines 102 from above and a gate insulating layer 2 and an insulating layer 6 are disposed therebetween. The pixel electrodes 701 and the data lines 303 may be in the same layer but the projections of which on the base substrate do not coincide with each other. The pixel electrodes 701 and the data lines 303 may also be in different layers, and at such times, there is an insulating layer therebetween and the projections thereof on the base substrate do not coincide with each other. The array substrate also includes common electrode lines (not illustrated) connected to the common electrodes 501.

In this embodiment, the common electrodes 501 are plate electrodes, the pixel electrodes 701 are slit pixel electrodes, and an insulating layer 6 is disposed therebetween. The common electrodes 501 are disposed above the gate lines 102 and insulating layers are disposed therebetween (the insulating layers comprising an insulating layer 6 and a gate insulating layer 2). And furthermore, the common electrodes 501 completely cover the gate lines 102. The data lines 303 and the common electrodes 501 do not overlap with each other, this is, the projections of the data lines 303 and the common electrodes 501 on the base substrate do not coincide with each other.

In this embodiment, the common electrodes have a width capable of completely covering the gate lines to shield the gate lines, while the projection of the data lines on the base substrate do not coincide with the projection of the common electrodes on the base substrate, which ensures minimizing of the coupling capacitance between the data lines and the common electrodes and can avoid the degradation in display quality caused by the coupling capacitance. Compared with the pixel structure in the conventional technology in which the common electrodes are used to shield the data lines, in the above pixel structure of the present invention, the driving load of the data lines will drop significantly, and the power consumption of the data driving IC will drop by about 35% while ensuring the same aperture opening ratio.

In addition, signals input into the data lines are voltage signals varying from time to time (the difference between the voltage signals input into the data lines and the common voltage signal is slight), signals input into the common electrodes are constant voltage signals and the ON-OFF voltage signals input into the gate lines will be much larger than the common voltage signals. Through shielding the gate lines by the common electrodes, even if coupling capacitance may be generated between the gate lines and the common electrodes, for a gate driving IC, its load is made much smaller than the load of the data driving IC of the structure in which the data lines are shielded by the common electrodes, so that the power consumption of the whole pixel structure will drop significantly and in turn, the power consumption of the array substrate and the display device, which adopt such pixel structure, will drop greatly.

Furthermore, the slit pixel electrodes 701 of each of the pixel electrodes are parallel with the gate lines 102, that is, extending in parallel with the gate lines 102. And as the orientation direction of the liquid crystal molecules usually coincide with the direction in which the slit pixel electrodes extend, i.e. rubbing direction of the orientation film on the pixel electrodes is disposed in parallel with the direction in which the slit pixel electrodes extend. Thus, the data lines 303 and the slit pixel electrodes 701 are perpendicular to each other. And then, the directions of the electric fields near both sides of the data lines are consistent with the direction in which the liquid crystal molecules are arranged, so that the liquid crystal molecules there are not subjected to moment and won't rotate. In this way, there is no light leakage on both sides of the data lines and a width of a shade layer corresponding to the data lines 303 will scale down. The aperture opening ratio is increased in such structure compared with the structure in which the slit pixel electrodes 701 are disposed extending in parallel with the data lines 303.

The array substrate of the embodiment of the present invention is not limited to the solution of the above embodiment. For example, the common electrodes may be slit common electrodes, and the pixel electrodes may be plate electrodes, under such circumstance, the common electrodes are located over the pixel electrodes and an insulating layer is provided between the common electrodes and the pixel electrodes, as long as projections of the slit common electrodes and the data lines on the base substrate do not coincide with each other. For example, the slit common electrodes are parallel with the gate lines 102. For example, such a slit common electrode is disposed over the gate lines and the projection of the slit common electrode on the base substrate shades the gate lines.

For example, both of the common electrodes 501 and the pixel electrodes 701 can be slit electrodes, both of which are interposed with each other without contacting and thus they can be located in the same layer. Of course, it needs to ensure that the projections of the slit common electrodes and the data lines on the base substrate do not coincide with each other. One slit of the slit common electrodes covers the gate lines entirely. The slit common electrodes and the pixel electrodes both are parallel with the gate lines 102.

Besides, the embodiment of the present invention also provides a display device including the array substrate mentioned above. The display device may be any product or component having display function, such as liquid crystal panels, e-paper, liquid crystal TVs, liquid crystal displays, digital frames, cell phones, tablet PC and so on.

Additionally, it is possible for a skilled person in the art to prepare the pixel structure, the array substrate and the display device according to the embodiments of the present invention by using well-known producing process. Compared with the conventional structure in which a resin layer is added, the use of masks is reduced by one time due to the decrease in the number of the resin layers. And since there is no need of forming via holes in the resin layer, the aperture opening ratio of the pixel structure is not affected under the same conditions, even when the size of the panel is larger. Therefore, the pixel structure, the array substrate and the display device according to the embodiment of the present invention can be used in a wider range of application.

The foregoing are merely exemplary embodiments of the invention, but are not used to limit the protection scope of the invention. The protection scope of the invention shall be defined by the attached claims.

## Claims

1. An array substrate comprising: a base substrate, a plurality of gate lines, a plurality of data lines and a plurality of pixel units defined by the gate lines and the data lines, which are formed on the base substrate, the pixel units comprising thin film transistors, pixel electrodes and common electrodes, wherein projections of the data lines and the common electrodes on the base substrate do not coincide with each other.

2. The array substrate according to claim 1, wherein the common electrodes are disposed over the gate lines.

3. The array substrate according to claim 1 or 2, wherein the pixel electrodes are slit pixel electrodes, the common electrodes are plate electrodes, and each slit of the slit pixel electrodes is disposed parallel with the gate lines.

4. The array substrate according to claim 1 or 2, wherein the common electrodes are slit common electrodes, the pixel electrodes are plate electrodes, and each slit of the slit common electrodes is disposed parallel with the gate lines.

5. The array substrate according to claim 4, wherein one of the slit common electrodes is disposed over the gate lines, and projection of the slit common electrodes on the base substrate covers projection of the gate lines on the base substrate.

6. The array substrate according to any one of claims 1 to 5, wherein an insulating layer is disposed between the pixel electrodes and the common electrodes.

7. The array substrate according to claim 1 or 2, wherein the pixel electrodes and the common electrodes are both slit electrodes and disposed alternatively in the same layer.

8. The array substrate according to any one of claims 1 to 7, wherein an insulating layer is disposed between the gate lines and the common electrodes.

9. The array substrate according to any one of claims 1 to 8, wherein an insulating layer is disposed between the pixel electrodes and the data lines.

10. The array substrate according to any one of claims 1 to 8, wherein the pixel electrodes and the data lines are disposed in the same layer.

11. A display device including the array substrate according to any one of claims 1 to 10.
